Europäisches Patentamt

European Patent Office

Office européen des brevets

(11) Publication number : **0 590 975 A1**

# (12) EUROPEAN PATENT APPLICATION

(21) Application number : 93307751.3

(22) Date of filing : 30.09.93

(51) Int. Cl.$^5$ : **C08G 59/18**, C08J 3/24,
C09J 163/00

(30) Priority : 02.10.92 JP 264973/92
18.08.93 JP 204203/93

(43) Date of publication of application :
06.04.94 Bulletin 94/14

(84) Designated Contracting States :
AT BE CH DE DK ES FR GB GR IE IT LI LU MC
NL PT SE

(71) Applicant : W.R. Grace & Co.-Conn.
Grace Plaza, 1114 Avenue of the Americas
New York, New York 10036-7794 (US)

(72) Inventor : Tsai, Hsi-Chuan
1196-5 Onmyo
Atsugi-Shi, Kanagawa-Ken (JP)
Inventor : Muroi, Souichi
651-50 Higashibara
Numazu-shi, Shizuoka-Ken (JP)
Inventor : Maehata, Hideo
1-24-8 Tsuruma
Daiwa-Shi, Kanagawa-Ken (JP)

(74) Representative : Jones, Helen Marjorie
Meredith
Gill Jennings & Every, Broadgate House, 7
Eldon Street
London EC2M 7LH (GB)

(54) Low viscosity and solvent-free one-component type epoxy resin adhesive composition.

(57) A low viscosity, solvent-free, non-polluting, one-component epoxy resin adhesive composition which is quick curing, excels in storage stability, bondability, cured physical properties and workability, is disclosed. The adhesive composition comprises polyfunctional epoxy compound which is a liquid at room temperature, a reactive diluent and a microencapsulated amine latent curing agent.

EP 0 590 975 A1

## Field of the Invention

The present invention relates to a novel one-component epoxy resin adhesive composition. More particularly, it relates to a solvent-free, non-polluting, one-component epoxy resin adhesive composition which not only has quick curability, excellent storage stability and bondability, but also yields a cured product which has excellent physical properties and also has a low viscosity and excellent workability.

## Background of the Invention

Because epoxy resins excel in bondability, corrosion resistance, mechanical properties, thermal properties and electrical properties, they are utilized commercially and widely as adhesives, paints, ink, laminates, castings and moldings, and electrical and electronic insulation materials. The epoxy resin formulations used for such applications can be either a one-component system or a two-component system.

The epoxy resin formulation which is most commonly used is the two-component system. The two-component system is made of an epoxy resin composition and a curing agent or its composition which are separately stored. When needed, they are weighed and mixed just prior to use. Therefore, the following disadvantages have been pointed out. (1) It is difficult to avoid mistakes in weighing and to consistently prepare a uniform curing composition. (2) Variation of the final properties due to incomplete mixing and defoaming can easily occur. (3) The reaction of the epoxy resin with the curing agent starts immediately after they are mixed, and the viscosity of the system gradually increases, goes through gelation and finally the system cures. Since the viscosity of the composition changes with the progress of time, it is impossible to automate the process. (4) The pot life of the composition is decided by the chemical structures and the ratio of the epoxy resin and the curing agent employed. Generally, the system with a faster curing rate has a shorter pot life. If a curing agent designed to have a quick cure is used, the composition can usually be cured at room temperature or at lower temperatures. However, it will naturally have a shorter pot life and this creates a need to frequently mix a small amount of the composition. Thus, use of such low temperature-curing compositions results in a reduction in working efficiency.

In contrast, the one-component system has no such difficulties, because the curing agent is added beforehand. However, a latent curing agent is needed in order to prepare an epoxy resin with good storage stability at room temperature. Several latent curing agents have been proposed for this purpose. The simplest latent curing agents are dispersion type latent curing agents which are solid and incapable of dissolving in the epoxy resin at room temperature but, when heated to near their melting points, capable of dissolving in the epoxy resin to quickly initiate the reaction. Such latent curing agents include dicyandiamide, phenol novolac, adipic dihydrazide, diallyl melamine, diamino maleonitrile, $BF_3$-amine complex, amine salts, imidazole derivatives and the like. Examples of other latent curing agents are amine imides which are activated by thermal decomposition; ketimines which are activated in contact with moisture; aromatic diazonium salts, diallyl iodonium salts, triallyl sulfonium salts and selenium salts which are activated by exposure to light; and microencapsulated curing agents which are coated with a material which can be destroyed by mechanical pressure or by heat. Of them, the most extensively studied one is the curing agent which is made by treating the solid particles of an amine compound/epoxy compound addition product with a polyfunctional isocyanate compound in the presence of a liquid epoxy resin. This technology is disclosed in Japanese Patent Publication (Kokai) No. SHO 64-70523 (1989), HEI 1-113480 (1989) and HEI 4-53818 (1992). In this case, it has been confirmed that an encapsulating layer is formed on the surface of the particles of the curing agent.

Recently, efforts have been made to improve productivity of the working line or coating line by automation in many areas where epoxy resins are applied, such as solder resist ink for electronic materials, conductive paints, adhesives, prepregs for lamination and primers for metallic anti-corrosion. In this case, it is necessary to have a one-component type epoxy resin curing composition which has both low viscosity and good physical properties upon curing. The viscosity of general- purpose bisphenol A diglycidyl ether epoxy resin at room temperature ranges from about 10,000 cP to about 15,000 cP. However, when the curing agent, the filler and the additive required for formulation are added, the viscosity of the composition increases. If automation of a spraying process is to be successful, the viscosity of the composition should be kept lower than about 1,000 cP. Attempts have been made to reduce viscosity effects by raising the working temperature above room temperature, or by adding either an organic solvent or a reactive diluent. With the former method, however, even when the above described latent curing agent is employed, the onset temperature of the curing reaction will be a problem. On the other hand, with the latter method, the solvent resistance and the reactive diluent resistance of the curing agent will be an important factor. Regardless of which method is used, the curing agent shows a tendency to lose its latency and accordingly, it is extremely difficult to have a one-component type curing composition. Also, the current tendency is to avoid the method of diluting with a volatile organic solvent, in order to save energy and prevent environmental pollution. Moreover, use of a reactive diluent, particularly a monofunctional epoxy compound, may risk changing the desirable physical properties of the cured product.

Thus, there is a strong desire to have a low viscosity, solvent-free, one-component epoxy resin adhesive which has excellent storage stability, workability, curing characteristics and cured physical properties as well as being non-polluting. In the current situation, however, hardly any one-component epoxy resin composition that can satisfy all of the above described requirements is known.

While epoxy resins have various outstanding advantages, such advantages are not fully available in the one-component adhesives because of various problems as described above.

To fully use the advantages of a one-component epoxy resin adhesive composition, it is highly desired to have a one-component epoxy resin adhesive which excels in storage stability, curing characteristics and cured physical properties and has low viscosity, excels in workability and is solvent-free and pollution-free.

The present inventors have carried out an extensive investigation to overcome the problems of the epoxy resin adhesive composition of the prior art and to develop a composition which can take full advantage of the one-component type epoxy resin adhesive composition, and have finally achieved the present invention.

## Objects of the Invention

It is an object of this invention to provide a novel one-component epoxy resin adhesive. Another object of this invention is to provide a low-viscosity epoxy resin adhesive that cures quickly, and yet has excellent workability and storage stability, and yields a cured product having excellent bondability and physical properties.

A further object of this invention is to provide a low-viscosity epoxy resin adhesive suitable for use in automated processes.

Yet another object of this invention is to provide a low-viscosity, sprayable epoxy resin adhesive that is formulated without volatile organic solvents.

Other object and advantages of the present invention will become apparent through the disclosure herein.

## Summary of the Invention

A low viscosity and solvent-free one-component epoxy resin adhesive composition in accordance with the invention comprises, as the essential components,

(A) 100 parts by weight of an epoxy resin which is a liquid polyfunctional epoxy compound at room temperature,

(B) 5 to 100 parts by weight of a reactive diluent and

(C) 1 to 100 parts by weight of a latent curing agent, which is a microencapsulated amine.

## Detailed Description of the Invention

For purposes of clarity in describing the present invention, the following term has the meaning stated below throughout the present description and the claims appended hereto:

"Room temperature" means a temperature of 20°C to 30°C.

Each of the components which constitute the low viscosity and solvent-free one-component type epoxy resin adhesive composition of the present invention will now be explained in detail.

The epoxy resin which is used as component (A) is not particularly limited as long as it is a polyfunctional epoxy compound which is liquid at room temperature.

Examples of such polyfunctional epoxy compounds include bifunctional epoxy compounds such as bisphenol A diglycidyl ether, bisphenol F diglycidyl ether, bisphenol S diglycidyl ether, diglycidyl phthalate, alicyclic diepoxy adipate and diglycidyl hydantoin; trifunctional epoxy compounds such as triglycidyl isocyanate and triglycidyl p-aminophenol; tetrafunctional epoxy compounds such as tetraglycidyl m-xylenediamine and tetraglycidyl diaminodiphenylmethane; epoxy compounds having more than 4 functional groups such as phenol novolac polyglycidyl ether. In order to lower the viscosity of the composition of the present invention, it is preferred to use the epoxy compound having a lower degree of polymerization. These epoxy compounds can be used alone or two or more kinds can be used together.

The reactive diluent which is used as component (B) of the epoxy resin adhesive composition of the present invention can be classified into two groups. One group is monofunctional or polyfunctional epoxy compounds having a low viscosity and a lower molecular weight and the other group is liquid acid anhydrides. The viscosity of the epoxy resin as component (A) can be effectively lowered to a lower level by using these reactive diluents. For practical purposes, it is desirable that the reactive diluents have a viscosity of not greater than 1,000 cP, preferably not greater than 500 cP at room temperature. Exemplary monofunctional epoxy compounds include n-butyl glycidyl ether, $C_{12-14}$ alkyl glycidyl ethers, allyl glycidyl ether, 2-ethylhexyl glycidyl ether, styrene oxide, phenyl glycidyl ether, cresyl glycidyl ether, p-sec-butylphenyl glycidyl ether, t-butylphenyl glycidyl ether, glycidyl methacrylate and glycidyl ester of a tertiary carboxylic acid. Exemplary bifunctional epoxy compounds include ethyleneglycol diglycidyl ether, polyethyleneglycol diglycidyl ether, propyleneglycol diglycidyl ether, polypropyleneglycol diglycidyl ether, butanediol diglycidyl ether, cyclohexane dimethanol diglycidyl ether, diglycidyl aniline and vinylcyclohexene dioxide. Exemplary trifunctional epoxy compounds include trimethylolpropane triglycidyl ether and glycerin triglycidyl ether. Exemplary liquid acid anhydrides are aliphatic acid anhydrides such as dodecenylsuccinic anhydride, alicyclic acid anhydrides such as methyltetrahydrophthalic anhydride, methylhexahydrophthalic anhydride, methylhymic anhydride and trialkyltetrahydrophthalic anhydrides.

Unlike non-reactive diluents such as organic solvents, the above described two types of reactive diluents are incorporated into the curing structure of the epoxy resin and accordingly, they have a significant effect on the physical properties of the cured product. Acid anhydrides are widely used conventionally as the addition polymerization type curing agent for epoxy resin, and they are known to give high heat resistance and excellent electrical and mechanical properties to the cured product. When the acid anhydrides are used as the diluents to lower the viscosity of the epoxy resin in the present invention, it is not always necessary to add them in stoichiometric quantity. The low viscosity epoxy compound, especially the monofunctional epoxy compound, has a very low viscosity and the highest diluting effect, but it may have an adverse effect on heat resistance because it tends to lower the crosslinking density of the cured product. Thus, selection of the type and the amount of the reactive diluent has to be carefully done by paying attention to the desired diluting viscosity and the cured physical properties. In the present invention, if the amount of the reactive diluent of component (B) is too low, it cannot serve to lower the viscosity of the epoxy resin composition. On the other hand, if the amount is too high, it can have an adverse effect on the storage stability and the cured physical properties of the composition. Thus, the added amount of component (B) is typically 5 to 100 parts by weight, preferably 10 to 50 parts by weight, per 100 parts by weight of the epoxy resin as component (A).

The microencapsulated amine type latent curing agent which is used as component (C) in the composition of the present invention is made of solid particles of the addition product (hereinafter referred to as "adduct") synthesized from an amine compound and an epoxy compound, and is an anionic polymerization catalyst comprising particles of a curing agent which has been made latent by the microencapsulation with 0.01 to 0.5 gram of a polyfunctional isocyanate compound per square meter of the surface area of the particles. The adduct synthesized from the amine compound and the epoxy compound may be of a pulverized shape or of a spherical shape. The amine compound/epoxy compound adduct of a pulverized shape can be obtained by the known addition reaction, followed by the pulverizing and grading processes. The spherical particles of the amine compound/epoxy compound adduct can be obtained by the precipitation or dispersion addition reaction which is characterized by using an organic solvent capable of dissolving the amine compound and the epoxy raw materials but incapable of dissolving the adduct produced in the presence an appropriate dispersion stabilizer. Such spherical particles of the amine compound/epoxy compound adduct are disclosed in Japanese Patent Publication (Kokai) Nos. HEI 4-31427(1992) and HEI 4-53818(1992) filed by the present applicant.

There is no particular restriction about the form of component (C) in the composition of the present invention, and it may be of either a powder type or a masterbatch type. When an amine adduct (C) which has not been microencapsulated is used, and the reactive diluent (B) are allowed to coexist in the same system, nearly all the particles of the adduct will dissolve in the reactive diluent, and curing will begin immediately. Thus, an effective encapsulating layer, that is, one which is insoluble to and resistant to the reactive diluent, plays a very important role. If the encapsulating layer is absent or very thin, the curability may improve but the stability will be poor. If the composition is cured at the ordinary curing temperature, for example, at 150°C, it is rather preferred to prepare a relatively thicker encapsulating layer thereby increasing the stability of the composition.

The polyfunctional isocyanate compound reacts with the hydroxyl group, the absorbed moisture and other active hydrogen functional groups existing on the surface of the particles of the amine/epoxy compound adduct and is transformed into a polymer such as polyurethane or polyurea to form an encapsulating layer. Therefore, the thickness of the encapsulating layer can be regulated by the amount of the polyfunctional isocyanate compound added and used in the surface reaction of the solid particles of the adduct. The average thickness of the encapsulating layer is typically 100 to 5,000 Å, and preferably 200 to 2,000 Å.

While the thickness (t) of the encapsulating layer can be measured by observing a sliced thin piece of resin encapsulated microcapsule using electron microscopy, it is also possible to calculate the thickness from the equation

$$t = W_s / \rho_s A$$

wherein

$W_s$      is the weight of the encapsulating layer;

4

$p_s$     is the density of the encapsulating layer; and

A     is the surface area of a particle of the adduct.

$W_s/A$ represents the amount of the polyfunctional isocyanate compound used per unit surface area of the particle of the adduct, and typically 0.01 to 0.5 gram and preferably 0.02 to 0.2 gram of the polyfunctional isocyanate compound per square meter of the surface area of the particle of the adduct is employed for obtaining the above described average thickness of the encapsulating layer.

The surface area A of the particle of the adduct can be calculated by using the specific surface area on a mass basis $S_W$ from the equation

$$A = W_a S_w$$

wherein

$W_a$     is the weight of the particles of the adduct.

Generally, the specific surface area Sw of a particle can be represented by the equation

$$S_w = \Theta/\Theta_c d_v p_a$$

wherein

$\Theta$     is called the specific surface shape factor and is 6 for a sphere;

$\Theta_c$     is called Carman's shape factor and is 1 for a sphere and is less than 1 for a non-sphere;

$d_v$     is the equivalent volume diameter of the particle; and

$p_a$     is the density of the particle.

Thus, the specific surface area of the particle of the adduct depends on the particle shape and the particle size distribution of powder. In the case of pulverized particles, the particle shape is irregular and the particle size distribution is broad. Therefore, it is a complicated task to make an accurate calculation. But by assuming that the particle shape is spherical and the particle size is uniform, it can be approximated by $S_W = 6/d_v p_a$, as is in the case of spherical particles. However, if the Carman's shape factor is taken into consideration, the real specific surface area will be 1 to 2 times greater than the calculated value.

Based on the above described relationship, the average thickness (t) of the encapsulating layer in the present invention can be represented by the following equation.

$$t = (W_s/W_a) (p_a/p_s) (d_v/6)$$

There are many ways to express and measure the average particle size and each of them will give different values. In this place, however, $d_v$ shown in the above equation represents the volume average Stokes particle size of the particle determined by gravitational sedimentation method or by centrifugal sedimentation method. It can be understood from this equation that the average thickness of the encapsulating layer is proportional to the weight ratio of addition of the polyfunctional isocyanate compound, i.e., $W_s/W_a$ and the volume average Stokes particle size $d_v$ of the particles. If $W_s/W_a$ and $d_v$ are known, the approximate average thickness of the encapsulating layer can be determined immediately from the above described equation. Also, it can be predicted that the actual average thickness of the pulverized particles under the same condition of $W_s/W_a$ and $d_v$ will be thinner than that of the spherical particles.

The addition amount of the polyfunctional isocyanate compound per unit surface area of the particles of the adduct ($W_s/A$) in the present invention can be calculated from the following equation.

$$W_s/A = (W_s/W_a) (d_v p_a/6)$$

Microencapsulation of the amine/epoxy compound adduct with the polyfunctional isocyanate compound can be carried out by reacting the polyfunctional isocyanate compound with the particles of the adduct formed by the addition reaction of an amine with an epoxy compound to form an encapsulating layer on the surface of the particles of the adduct.

Exemplary polyfunctional isocyanate compounds include the mononuclear and polynuclear species of tolylene diisocyanates and diphenylmethane-4,4'-diisocyanate; hydrogenated diphenylmethane-4,4'-diisocyanate, 1,5-naphthalene diisocyanate, isophorone diisocyanate, hexamethylene diisocyanate, xylylene diisocyanate, hydrogenated xylylene diisocyanate, tetramethylxylene diisocyanate, 1,3,6-hexamethylene triisocyanate, lysine diisocyanate, triphenylmethane triisocyanate, tris(isocyanate phenyl)thiophosphate, polyfunctional isocyanate compounds formed by addition of such compounds such as polymethylene polyphenylisocyanate and other active hydrogen-containing compound and any mixtures thereof. Such polyfunctional isocyanate compounds are selected from those which can be soluble in the organic reaction medium.

The amine compound/epoxy compound adduct that has been microencapsulated with the polyfunctional isocyanate compound is made of solid particles, and when it is added to the above described epoxy resin system, it acts as a filler and tends to cause an increase in viscosity. It has been found that powdered curing agents and spherical particles are superior to masterbatch curing agents and pulverized particles, respectively, because the former make a smaller contribution to the viscosity. When the masterbatch type curing agent is used as component (C) of the composition of the present invention, it can be prepared by dispersing the amine compound/epoxy compound adduct having a volume average particle size of 0.05 to 3 mm in a liquid epoxy resin, followed by treating with 5 to 100 parts by weight of a polyfunctional isocyanate compound per 100 parts by weight of the adduct. Also, the curing agent may be prepared by dispersing the amine compound/epoxy compound adduct having a volume average particle size of 1 to 30 mm in a liquid epoxy resin, followed by treatment with 2 to 20 parts by weight of polyfunctional isocyanate compound per 100 parts by weight of the adduct. The details of the former method of preparation are described in Japanese Patent Publication (Kokai) No. HEI 4-53818(1992) filed by the present applicant and the details of the latter preparation method are disclosed in Japanese Patent Publication (Kokai) No. HEI 4-320416 (1992) filed also by the present applicant. As to the powdered curing agent, an excess amount of a polyfunctional epoxy compound and then the polyfunctional isocyanate compound are added to the reaction system to prepare the microencapsulated particles of the adduct and, in addition, an encapsulating layer formed from the polyfunctional isocyanate compound on that epoxy encapsulating layer, or having an encapsulating layer formed from a mixture of the both. In such methods of preparation, it is possible to prepare a powdered latent curing agent for an epoxy resin having a quick curability at low temperatures and excellent storage stability at room temperature, as well as good solvent resistance and cured physical properties by adding and reacting a carboxylic acid at any of the stages prior to addition of the polyfunctional isocyanate compound. The details of such a method are described in Japanese Patent Application No. HEI 4-11199(1992) filed by the present applicant. In the present case, the adduct was modified by a polyfunctional epoxy compound and a carboxylic acid prior to the encapsulation reaction with the polyfunctional isocyanate compound. With this technique, a stronger encapsulating layer is formed, and it is even more effective to control the latency, the curing characteristics and the reactive diluent resistance of the curing agent.

The details of the preparation of the microencapsulated amine type latent curing agent which is used as component (C) in the composition of the present invention will now be explained in detail.

The amine compounds and the epoxy compounds which can be employed as the starting materials for the preparation of the latent curing agent as Component (C) of the present invention are selected based on the consideration of the properties of the adduct as the curing agent. Important aspects are its chemical structure which promotes the curing reaction by anionic polymerization, its melting point, and its compatibility in its molten state with the epoxy resin which will be cured, its quick curability and its effect of addition (high curing reactivity with a smallest possible amount of addition).

While any kind of amine compound can be used for the present invention, the selection thereof will be determined by the kind of epoxy compound to be cured since, in the present invention, the reaction has to be stopped at the state of addition reaction with avoidance of polymerization reaction in order to synthesize a pure adduct. While it is possible to use any kind of amine compound which has at least one active amino-hydrogen with the monofunctional epoxy compounds, the polyfunctional epoxy compounds require an amine compound which has only one active aminohydrogen, i.e., having a secondary amino group, in its molecule which contributes to the addition reaction with the epoxy group. Use of compounds having at least one tertiary amino group, i.e., having no active hydrogen, is also permitted, since the presence of the tertiary amino group is desirable for increasing the concentration of amino groups which contribute to the curing reaction of the adduct, or in other words, to increase the effect of addition of the curing agent. If this condition for combination is met, any combinations of one, two or more kinds of amine compounds can be employed.

Exemplary amine compounds which can be combined with polyfunctional epoxy compounds include imidazoles represented by 2-methylimidazole and 2,4-dimethylimidazole; imidazolines represented by imidazoline and 2-methylimidazoline; piperazines represented by N-methylpiperazine and N-hydroxylethyl piperazine; anabasines represented by anabasine; pyrazoles represented by 3,5-dimethylpyrazole; purines represented by tetramethylquanidine and purine; and triazoles represented by 1,2,4-triazole.

Any kind of epoxy compound can be employed as the other starting material for the adduct. Exemplary epoxy compounds include monofunctional epoxy compounds such as n-butyl glycidyl ether, styrene oxide and phenylglycidyl ether; bifunctional epoxy compounds such as bisphenol A diglycidyl ether, bisphenol F diglycidyl ether, bisphenol S diglycidyl ether and diglycidyl phthalate; trifunctional epoxy compounds such as triglycidyl isocyanurate, triglycidyl p-aminophenol; tetrafunctional epoxy compounds such as tetraglycidyl m-xylene diamine and tetraglycidyl diaminodiphenylmethane; and epoxy compounds having more functional groups such as cresol novolac polyglycidyl ether and phenol novolac polyglycidyl ether. Furthermore, the epoxy compounds as component (A) or component (B) as described above can also be employed. The selection of epoxy compounds is also determined by the type of the amine compound to be combined. Thus, while the amine compounds having only one active hydrogen can be combined with any kind of epoxy compounds, monofunctional epoxy compounds alone can be combined with the amine compounds having two or more active hydrogens.

The epoxy compounds are also selected by considering the melting point of the adduct formed and the compatibility of the adduct in its molten state with respect to the epoxy resin which is to be cured. Since the majority of the epoxy resins to be cured comprise bisphenol A diglycidyl ether, this compound which possesses advantageous compatibility and cost savings, is most typically used as the starting material for the preparation of an adduct.

With an epoxy compound, the concentration of epoxy groups is expressed by a reciprocal number of "epoxy equivalent weight (gram per equivalent)". Lower epoxy equivalent weights give higher concentrations of epoxy groups. Higher concentrations of epoxy groups are desirable for the increase of concentration of tertiary nitrogen atoms in the adduct. Thus, a lowest possible epoxy equivalent weight is desirable for the epoxy compound. Epoxy compounds having an epoxy equivalent weight of, at most, 1,000, and preferably at most 500 are typically employed.

The melting point of the amine compound/epoxy compound adduct is influenced by the chemical structures of the amine compound and the epoxy compound employed, the method of addition, the structure of the adducts formed, and the ratio of the addition of the epoxy compound to the amine compound. With a proper selection of these factors, the synthesis of desired adducts having a low melting point to a high melting point is possible. While higher melting points will make the adduct easier to handle, they will also raise the temperature of onset of the curing reaction. Therefore, from the viewpoint of curability, lower melting points are preferred. However, if workability, particularly the workability during summer season, is taken into consideration, the melting point has to be at least 50°C.

The amine compound/epoxy compound adduct is usually synthesized at an equivalent ratio of 1.0 or in an excess amount of the amine compound. However, when a monofunctional epoxy compound is used, an excess amount of the epoxy compound will lower the melting point of the adduct formed therefrom. On the other hand, when a polyfunctional epoxy compound is used, an excess amount of the polyfunctional epoxy compound will cause competition between the addition reaction and the polymerization reaction, and the melting point of the adduct will rise. Although there is no particular restriction in the present invention about the reaction equivalent ratio of the epoxy compound and the amine compound in the preparation of the amine compound/epoxy compound adduct, the stoichiometric amount serves as the basis.

When a powder type curing agent is used as component (C) of the composition of the present invention, it can be prepared by the method as described in Japanese Patent Application No. HEI 4-11199 (1992) filed by the present applicant. Also in such an embodiment, the same amine compound and the same epoxy compound which form the particles of the adduct and the same polyisocyanate compound which forms the encapsulating layer as described above are used. The details are as follows.

In the preparation of pulverized type particles of the adduct in this embodiment of the present invention, based on the above described equivalent ratio, an excess amount of a polyfunctional epoxy compound is used during the reaction of the amine compound, and the epoxy compound in the presence or absence of any solvent to form an amine compound/epoxy compound adduct which is mixed with part of the polymerized epoxy resin formed from the polyfunctional epoxy compound, and then the solvent is removed from the reaction system. The product thus obtained is ground, pulverized and classified to obtain desired adduct particles. In another embodiment, the amine compound/epoxy compound adduct obtained by removing the solvent from the reaction system is ground, pulverized, and classified to obtain particles of the adduct, and then the particles are re-dispersed in a solvent and further reacted with a polyfunctional epoxy compound to form an encapsulating layer of a polymer on the surface of the adduct particles.

Although the excess amount of the polyfunctional epoxy compound may change depending on the particle size of the finally formed particles of the adduct, typically 1 to 100 parts by weight, preferably 5 to 50 parts by weight of the polyfunctional epoxy compound are used based on 100 parts by weight of the adduct. If the amount is less than 1 part by weight, latency of the latent curing agent for epoxy resin will not be sufficient, and the one-component epoxy resin curing composition added with such a curing agent will not have sufficient storage stability. On the other hand, if the amount exceeds 100 parts by weight, the curability at lower temperatures will be lost and thus, such an amount is not practical.

Any polyfunctional epoxy compounds can be used to form the encapsulating layer or the mixed part by the polymerized epoxy resin. When the epoxy compound which reacts with the amine compound to form an adduct is a polyfunctional epoxy compound, it may be the same as the epoxy compound which forms the adduct or may be of different type. The stage to add such an additional polyfunctional epoxy compound, as described above, may be prior to the reaction of adduct formation, i.e. at the feeding stage of the starting materials or may be during or after completion of the reaction of adduct formation or after obtaining the particles of the adduct with a desired particle size by removing the solvent, crushing, pulverizing and classifying.

The reaction of the amine compound with the epoxy compound is carried out in the presence or absence of any reaction solvent. However, from the viewpoint of removal of the reaction heat or from the viewpoint of the homogeneous reaction, it is preferred to carry out the reaction in the presence of a solvent. Any known solvents which are capable of dissolving the amine compound and the epoxy compound can be used for this reaction. Examples of such solvents include ethanol, n-butanol, acetone, methyl ethyl ketone, methyl iso-butyl ketone, tetrahydrofuran, ethyl acetate, n-butyl acetate, cellosolve, benzene, toluene and xylene and any mixtures thereof.

By removing the reaction solvent after completing the reaction of adduct formation, the adduct is obtained as a solid mass. Removal of the solvent is carried out by evaporation at a reduced pressure under heating. Then, the solid mass of the adduct is crushed, pulverized and classified to obtain particles of the adduct having a desired particle size. To pulverize the adduct, first, the solid mass is crushed by a cutter mill or a pin mill, and then finely pulverized to particles having a volume average particle size of several microns in a jet mill or a centrifugation-classification type mill. The classification of the finely pulverized particles of the adduct is carried out by a sieve or a dry centrifugal air classifier such as a micron separator and an air separator, and particles having a desired particle size are taken out. The solvent to be used for re-dispersing the pulverized and classified particles of the adduct by such processes may be the same as or different from the solvent which is used in the reaction of adduct formation. Solvents incapable of dissolving the adduct are used as the solvents for the re-dispersion. Exemplary solvents include acetone, methyl ethyl ketone, methyl iso-butyl ketone, tetrahydrofuran, ethyl acetate, n-butyl acetate, benzene, toluene, xylene, cyclohexane and n-hexane. Further, high-speed mechanical agitation and a dispersion stabilizer can be used to form a stable dispersion of the adduct particles.

The important characteristic feature of this embodiment is to react a carboxylic acid with the formed amine compound/epoxy compound adduct. The carboxylic acid may be reacted at any of the stages before encapsulation. For example, the carboxylic acid can be added to the reaction system after adduct formation but before removal of the reaction solvent and then reaction can be allowed to continue. It is also possible to add the carboxylic acid to the reaction system after the particles of the adduct are re-dispersed in the solvent. Furthermore, it is possible to add the carboxylic acid into the reaction system after the addition of a second polyfunctional epoxy compound.

The reaction with the carboxylic acid is useful because it reduces the temperature of onset of cure and therefore imparts quick curability at low temperatures to the altered adduct particles.

Any kind of carboxylic acid or mixture of acids can be used for this purpose and they may be monocarboxylic acids or polycarboxylic acids, or aliphatic carboxylic acids, alicyclic carboxylic acids or aromatic carboxylic acids so long as they are soluble in the reaction system.

Exemplary carboxylic acids include aliphatic monocarboxylic acids such as acetic acid, trimethylacetic acid, propionic acid, n-butyric acid, isobutyric acid, 2-methylbutyric acid, n-valeric acid, isovaleric acid, 3-methylvaleric acid, hexanoic acid, 2-ethylhexanoic acid, octanoic acid, n-decanoic acid and lauric acid; aliphatic dicarboxylic acid such as tartaric acid, malonic acid, methylmalonic acid, dimethylmalonic acid, succinic acid, methylsuccinic acid, 2,2-dimethylsuccinic acid, 2,3-dimethylsuccinic acid, glutaric acid, 2-methylglutaric acid, adipic acid, suberic acid, sebacic acid and dodecane dicarboxylic acid; alicyclic monocarboxylic acids such as cyclopropane carboxylic acid, 1-methylcyclopropane carboxylic acid, cyclobutane carboxylic acid, cyclopentane carboxylic acid, cyclohexane carboxylic acid and cycloheptane carboxylic acid; alicyclic dicarboxylic acids such as 1,1-cyclobutane dicarboxylic acid, 1,2-cyclohexane dicarboxylic acid, 1,4-cyclohexane dicarboxylic acid and hexahydro-4-methylphthalic acid; aromatic carboxylic acids such as benzoic acid, p-t-butylbenzoic acid, o-benzoylbenzoic acid, toluic acid, phthalic acid, isophthalic acid, salicylic acid, phenylacetic acid, diphenylacetic acid, p-methoxyphenylacetic acid, phenoxyacetic acid, protocatechuic acid, benzylic acid and trimellitic anhydride.

The amount of the carboxylic acid may vary depending on the adduct used and the carboxylic acid selected, and is typically 1 to 200% by weight, preferably 5 to 100% by weight based on the weight of the adduct.

The above described treatments can produce particles made of the amine compound/epoxy compound adduct which has been treated with the carboxylic acid and also has an encapsulating layer of epoxy.

By a subsequent reaction with a polyfunctional isocyanate compound, the above described particles can be encapsulated with yet another layer. Without such encapsulating layers, the latency of the curing agent particles cannot be obtained.

In another embodiment, component (C) can be prepared by reacting spherical particles of the adduct with a carboxylic acid at any stage before encapsulation with the isocyanate. The resulting spherical particles have an outer layer formed by a polyfunctional isocyanate compound on an inner layer formed by either a polyfunctional epoxy compound or a mixture of epoxy compounds formed by adding an additional polyfunctional epoxy compound during the course of the reaction of the amine compound with the epoxy compound or adding the additional polyfunctional epoxy compound after completion of that reaction.

The amine compound, the epoxy compound, the additional polyfunctional epoxy compound, the polyfunctional isocyanate compound, the carboxylic acid and their relative amounts which can be used in this embodiment can be the same as those which are used in the preparation of the above described pulverized type particles of the adduct.

Formation of the spherical particles of the amine compound/epoxy compound adduct in the embodiment can only be realized by the precipitation or dispersion addition reaction proposed in Japanese Patent Publication (Kokai) No. HEI 4-31427 (1992) by the present applicant. That is, formation of the spherical particles of the adduct in this embodiment of the present invention is carried out by making a stable dispersion of the adduct particles in a selected organic solvent. The solvent must be capable of dissolving raw materials, but incapable of dissolving the reaction product (the adduct) in the presence of an appropriate dispersion stabilizer. By this method the adduct can be obtained in the form of spherical particles of a controlled size in one step.

It is also important to select a solvent which can dissolve the amine compound, the epoxy compound and dispersion stabilizer which will be described below, but can precipitate the adduct in the form of particles without dissolution. Generally, a substance can dissolve in a solvent having a similar polarity. The level of the polarity of a solvent or a substance is often expressed by a solubility parameter having units $(cal/cm^3)^{1/2}$. A typical range of solubility parameters of epoxy compounds will be 8 to 11 $(cal/cm3)^{1/2}$, and that of amine compounds will be 8 or greater, and that of the amine compound/epoxy compound adduct will be 11 to 16. Thus, in order to achieve the desired precipitation or dispersion addition reaction of the present invention, it is suitable to use a solvent having a solubility parameter of 8 to 11.

Examples of such solvents that can be used in the present invention are methyl ethyl ketone, methyl isobutyl ketone, methyl isopropyl ketone, acetone, n-butyl acetate, isobutyl acetate, ethyl acetate, methyl acetate, tetrahydrofuran, 1,4-dioxane, cellosolve, ethylene glycol monomethyl ether, diethylene glycol dimethyl ether, anisole, toluene, p-xylene, benzene, cyclohexane, methylene chloride, chloroform, trichloroethylene, chlorobenzene and pyridine. These solvents can be used alone, or two or more solvents can be used together. It is also possible to use the solvents having a solubility parameter outside the range of 8 to 11 if two or more solvents are combined to bring the solubility parameter within the above described specified range. However, since the precise solubility parameter of the solvents to be used may naturally differ depending on the chemical structures of the amine compound and the epoxy compound, it is essential to make a precise selection for each individual situation. If the selection of the solvent is not precise, the precipitation reaction may smoothly progress but the adduct may re-dissolve in the solvent and as a result, the yield of the adduct is decreased.

The dispersion stabilizer prevents the particles of the adduct from aggregating and causing separation. Polymeric compounds having strong affinity for both the organic solvent and the adduct are suitable. From the standpoint of chemical structure, any graft copolymers, block copolymers, random copolymers, and other copolymers may be employed.

Exemplary graft copolymers include poly[(methyl methacrylate-co-methacrylic acid)-g-styrene], poly[methyl methacrylate-co-2-hydroxyethyl methacrylate)-g-styrene], poly[(methyl methacrylate-coglycidyl methacrylate)-g-styrene], poly[(styrene-coglycidyl methacrylate)-g-styrene], poly(2-hydroxyethyl methacrylate-g-styrene), poly(2,3-dihydroxypropyl methacrylate-g-styrene), poly(2-acrylamido-2-methylpropane sulfonic acid-g-styrene), poly(vinyl acetate-g-styrene), poly(methacrylic acid-g-styrene), poly(acrylamide-g-styrene), poly(ethylene oxide-g-styrene), poly(4-vinyl-N-ethylpyridium bromide-g-styrene), poly[(methyl methacrylate-co-methacrylic acid)-g-C1~12 alkyl methacrylate], poly[(methyl methacrylate-co-fluoroalkyl acrylate)-g-methyl methacrylate], poly[(methyl methacrylate-co-glycidyl methacrylate)-g-methyl methacrylate], poly[styrene-coglycidyl methacrylate)-g-methyl methacrylate], poly(vinyl alcohol-g-methyl methacrylate), poly [(methyl methacrylate-co-glycidyl methacrylate)-g-methacrylic acid], poly(butadiene-g-methacrylic acid), poly(methyl methacrylate-g-2-hydroxyethyl methacrylate), poly(methyl methacrylate-g-N-methylol acrylamide), poly(2-hydroxyethyl methacrylate-g-N-methylol acrylamide), poly(methyl methacrylate-g-12-hydroxystearic acid), poly[(methyl acrylate or ethyl acrylate-co-methacrylic acid)-g-12-hydroxystearic acid), poly[(styrene-co-methacrylic acid-g-l2-hydroxystearic acid], poly[(ethyl acrylate-co-methacrylic acid)-g-lauryl methacrylate], poly(vinyl acetate-g-2-ethylhexyl acrylate) and poly(chloroprene-g-2-ethylhexyl acrylate); block copolymers such as poly(vinyl acetate-b-styrene), poly(styrene-b-dimethyl-siloxane), poly(styrene-b-methacrylic acid), poly(lauryl methacrylate-b-methacrylic acid), poly(ethylene oxide-b-styrene-b-ethylene oxide) and poly(12-hydroxystearic acid-b-ethylene oxide-b-12-hydroxystearic acid); exemplary random copolymers such as poly(vinyl acetate-co-vinyl alcohol), poly(N-vinylpyrrolidone-co-vinyl acetate), poly(N-vinylpyrrolidone-co-methyl methacrylate) and poly(long chain methacrylate or acrylate-co-N-vinylpyrrolidone); and other polymers such as carboxylic acid-modified glycol polyphthalates and quaternarized amine-modified polyesters.

In the above described embodiment of the present invention, first, spherical particles of the adduct have an encapsulating epoxy layer which can be obtained by allowing excess amount of a polyfunctional epoxy compound to exist at the state of the particle formation of the adduct.

Any polyfunctional epoxy compounds can be used as the encapsulating layer. If the epoxy compound used to make the adduct is polyfunctional, the epoxy layer may be created merely by adding an excess of that material, either at the beginning of the reaction to form the adduct, or after adduct formation is complete. A different epoxy compound may be added, as described above, before the start of the reaction to form the spherical particles of the adduct, i.e. at the feeding stage of the starting materials, or during the reaction to form the spherical particles of the adduct, or after completion of the reaction to form the spherical particles of the adduct.

The resulting spherical particles of amine compound/epoxy compound adduct can be reacted with a carboxylic acid at any stage before the subsequent reaction of a polyfunctional isocyanate compound with the spherical particles of the adduct. For example, when an excess amount of the polyfunctional epoxy compound is to form the adduct, then the spherical particles will have an encapsulating layer made of a the excess epoxy. The carboxylic acid can be added to the reaction system and the reaction can be carried out before or after the reaction of the amine compound with the epoxy compound has 100% completed. Also, when a different polyfunctional epoxy compound is added and reacted to form an encapsulating layer after the formation of the spherical particles of the adduct, the carboxylic acid may be added and reacted after the formation of the above described particles or after formation of the above described encapsulating layer.

By these reactions, the onset temperature of the curing reaction of the spherical particles of the curing agent can be reduced to impart a quick curability at low temperatures.

Regardless of whether the adduct particles are pulverized or spherical, a polyfunctional isocyanate compound is allowed to react with the particles of the adduct after completion of the above described processes to obtain an outer encapsulating layer formed by either the polyfunctional isocyanate compound or a mixture of isocyanate and an epoxy on the surface of the resulting particles. Without formation of such encapsulating layers the latency of the curing agent particles cannot be expected.

The polyfunctional isocyanate compound and its addition amount which can be used in the above-described reactions can be the same as described above. Particle size of the final product is important due to its effect on the viscosity of the adhesive and cure properties of the final product. The particle size is controlled by the types of the starting materials, the solvent, the reaction conditions, the chemical and molecular structures of the dispersion stabilizer and the amount of the dispersion stabilizer. Of these factors, the decisive factors are the chemical structure and the molecular structure of the dispersion stabilizer. For example, in the precipitation or dispersion addition reaction of 2-methylimidazole with bisphenol A diglycidyl ether in methyl iso-butyl ketone, micron-sized particles are formed by using a graft copolymer of poly [(methyl methacrylate-co-methacrylic acid)-g-styrene] as the dispersion stabilizer. In contrast, a quaternarized amine-modified polyester dispersion stabilizer will give particles of a submicron size. Although the particle size depends on the chemical structure of the dispersion stabilizer, generally, a smaller molecular weight of dispersion stabilizer will yield the adduct particles with a larger particle size. The next significant factor to affect the formation of particles is the reaction conditions. Generally speaking, the adduct particle size decreases with increased concentrations of the dispersion stabilizer, higher reaction temperatures and faster agitation speeds, and with decreased concentrations of the starting materials and low conversions. With an appropriate combination of these factors, the volume average particle size of the resulting particles of the adduct or curing agent can be controlled to 0.05 mm to 100 mm.

It is considered that the encapsulating layers can be formed on the surfaces of the adduct particles by the reaction of the polyfunctional epoxy compound and the polyfunctional isocyanate compound with the adduct particles having a desired average particle size. Accordingly, the final average particle size of the encapsulated latent curing agent is larger than that of the adduct particles used. For the volume average particle size of the above described adduct particles and the addition amounts of the polyfunctional epoxy compound and the polyfunctional isocyanate compound, the volume average particle size of the finally obtained spherical particles of the latent curing agent of the present invention ranges from 0.1 mm to 200 mm.

In a reactor a desired amount of a solvent is charged, and the selected amine compound, epoxy compound and dispersion stabilizer are dissolved. When the reaction system is heated to a desired temperature with a constant rate of agitation, the reaction mixture which is initially transparent will become opaque as the adduct particles are formed. With the progress of the reaction, the system increases its opaqueness and shows a milky white color appearance which is a characteristic feature of the dispersion. At this stage, if the amounts of the amine compound and the epoxy compound are stoichiometric, spherical particles of the amine compound/epoxy compound adduct are formed. When a polyfunctional epoxy compound is used and an excess of the polyfunctional epoxy compound is used, spherical particles of the adduct form with an encapsulating layer of epoxy compound on the surface. In the former case, an encapsulating layer can be added by subsequent addition of the polyfunctional epoxy compound and continued heat and stirring. Furthermore, an outer layer of isocyanate or a mixed encapsulating layer of isocyanate and epoxy can be formed by adding the polyfunctional isocyanate compound and continuing heat and stirring after formation of the above described adduct and the epoxy encapsulating layer. It is believed that the carboxylic acid penetrates into the interior of the particles at a molecular level from the surface of encapsulating epoxy layer or from the surface of the adduct to modify the adduct (which may be considered to form an ion complex). The result is that the rate of curability at low temperatures is increased. Also, the carboxylic acid can contribute to the encapsulating layer by reacting with the polyfunctional isocyanate compound, resulting in a stronger encapsulating layer and improving the solvent resistance and latency of the curing agent particles.

After completion of these reactions, the dispersion is cooled down to room temperature, and dried. The particles may be spray-dried using a spray dryer designated for an organic solvent system or dried by a sedimentation process.

The spray-drying technique is the most effective, and with a cooling device attached to the spray dryer the solvent used in the reaction can be almost completely recovered and can be advantageously reused for the next reaction. When no spray dryer is used, it is fairly difficult to recover the particles of curing agent because the particle size is too small for separation by the ordinary filtration method or the gravitational sedimentation method. In this case, a flocculent is added to the dispersion, and the sedimented particles are recovered by filtration or centrifugation. When dried at a predetermined temperature, the particles of curing agent can be recovered in a 100% yield. The used organic solvent is subjected to fractional distillation and can be reused as in the case of spray drying.

Further, a masterbatch type curing agent to be used as component (C), it can be prepared by the following method.

Masterbatch type curing agents can be prepared by dispersing the particles of the adduct in a liquid epoxy resin, and then treating them with the above-described polyfunctional isocyanate compound. The adduct particles which can be used for the preparation of the masterbatch curing agents may be either pulverized particles or spherical. What is basically important is the viscosity and hydroxyl number of the liquid epoxy resin which is used as the dispersion medium of the masterbatch. The hydroxyl groups react with a polyfunctional isocyanate compound to increase the viscosity of the system and in an extreme case, the system may gel. Thus, it is required that the liquid epoxy resin to serve for this purpose does not contain any hydroxyl group or may contain an extremely low level of hydroxyl groups. Also, it is preferred that the viscosity is as low as possible. Lower viscosities of the dispersion medium enable particles of the adduct to disperse at a high concentration. In addition to this basic requirement, the formulating epoxy resin and the curing composition should be taken into consideration. Since the epoxy resin to be used as the dispersion medium will be incorporated into the cured structure, such consideration is inevitable. For the formulation to create high heat resistance, an epoxy resin to serve for this purpose should suitably be selected as the dispersion medium. For the formulation to reduce corrosion of metals, an epoxy resin with a low content of hydrolyzable chlorine should be selected as the dispersion medium. To prepare a masterbatch type curing agent, first, the adduct particles are uniformly dispersed in an epoxy resin which serves as the dispersion medium. Since fine particles often form secondary particles, mechanical dispersion treatment is required in order to disperse them as primary particles. For example, blending in a three-roll mill can be employed. Second, the epoxy resin where the adduct particles are dispersed is heated at a temperature lower than the melting point of the curing agent with a constant rate of agitation. Third, when a predetermined temperature is attained a, polyfunctional isocyanate compound is added at such a rate that does not cause excessive elevation of the temperature, and heating is continued for the treatment of the adduct particles. The concentration of the polyfunctional isocyanate compound in the system decreases with the progress of reaction, and complete disappearance of isocyanate groups is regarded as the end point of the reaction. With this treatment, an encapsulating layer can be formed on the surface of the adduct particles.

The formulating amount of component (C) in the composition.of the present invention may vary depending on the targeted curing conditions and the viscosity of the composition. Small amounts will retard the curing rate and accordingly are not practical. On the other hand, excess amounts will increase the viscosity of the composition to deteriorate workability. Thus, the formulating amount of component (C) is typically 1 to 100 parts by weight, preferably 5 to 50 parts by weight based on 100 parts by weight of the epoxy compound as component (A).

If desired or necessary, other known curing agents may be added in the composition of the present invention. Exemplary known curing agents include dicyandiamide, acidic hydrazide, diamino maleonitrile, diallyl melamine, poly(piperidine sebacic acid)amide, phenolic resin and melamine resin.

The formulating amount of the known curing agent which can be employed in the present invention is typically 0.1 to 50 parts by weight based on 100 parts by weight of component (A).

If desired or necessary, organic or inorganic modifying agent such as sedimentation inhibitors, plasticizers, fillers and pigments may be added. Examples of suitable sedimentation inhibitors include powder of bentonite, kaolin, silica and block/graft copolymers. Examples of suitable plasticizers include epoxylated cadanol, polypropylene glycol diglycidyl ether and polymerized aliphatic acid polyglycidyl esters. Examples of suitable fillers include glass fibers, asbestos fibers, carbon fibers, calcium silicate, atabaljite, barite, kieselguhr, magnesium oxide, titanium oxide, iron oxide, magnesium hydroxide, aluminium hydroxide, quartz powder, fused silica powder, calcium carbonate, magnesium carbonate, talc, feldspar power, mica, anhydrous gypsum, carbon black, graphite, silver powder, aluminum powder and iron powder. They can be selected, based on the increased amount of added composition, reduction of shrinkage caused by curing the epoxy resin, improvement of a mechanical property, improvement of heat conductivity and electrical conductivity, and fire retardation purposes. Examples of suitable pigments include inorganic pigments such as cadmium yellow, chromium yellow, rouge, zinc white, titanium white and carbon black; and organic pigments such as azo dyes, quinoline dyes, anthraquinone dyes and phthalocyanin dyes.

In order to improve the mechanical strength of the cured product, silicone, urethane resin or rubber-modified epoxy resin and liquid rubber represented by CTBN may also be blended.

The formulating amount of the above described modifying agent may vary depending on the object and is typically 0.1 to 100 parts by weight, preferably 1 to 50 parts by weight based on 100 parts by weight of the combined amount of component (A) and component (B).

In the preparation of the one-component type epoxy resin adhesive composition of the present invention, any known formulation method can be employed. The composition of the present invention can easily be obtained by merely mixing and blending homogeneously the essential components (A), (B), and (C) and, if desired or necessary, another known curing agent or a modifying agent in a homomixer, planetary mixer, three-roll mill or a kneader. Since the composition of the present invention has quick curability, excellent storage stability, bondability and cured physical properties and, in addition, has low viscosity without containing an volatile organic solvent, operations such as spraying, impregnation and casting can be automated, and a clean working environment can be maintained. Thus, the composition of the present invention can be regarded as substantially superior to the more conventional epoxy resin adhesive compositions.

The present invention will be explained in more detail by the following examples and comparative examples which are given for illustrative purposes and are not meant to limit the invention described herein.

Component (A) and Component (B) used in the examples and comparative examples are as follows.

## Component (A): Polyfunctional Epoxy Compound Liquid at Room Temperature

EP825: Bisphenol A diglycidyl ether epoxy resin having an epoxy equivalent weight of 175 and a viscosity at 25°C of about 6,000 cP ("EPIKOTE∗ 825", a product of Yuka Shell Epoxy K.K.)

EP807: Bisphenol F diglycidyl ether epoxy resin, having an epoxy equivalent weight of 170 and a viscosity at 25°C of about 2,200 cP ("EPIKOTE∗ 807", a product of Yuka Shell Epoxy K.K.)

## Component (B): Reactive Diluent

CGE : Cresyl glycidyl ether (a mixture of m-CGE and p-CGE, a product of Sakamoto Yakuhin Kogyo K.K.)
CYH : Cyclohexane dimethanol diglycidyl ether ("HEROXY MK-107", a product of ACI-Japan Limited)
MHHPA: Methyl hexahydrophthalic anhydride ("HN-5500E", a product of Hitachi Kasei Kogyo K.K.)

## Component C: Curing Agent "C" (Crushed, Non-encapsulated Curing Agent for Comparative Examples 1 and 2)

Xylene 600 g and 2-methylimidazole (hereinafter referred to as "2Mz", a product of Aldrich Chemical Co., Inc.) 300 g (3.65 equivalent) were charged in a 3,000 mP four-necked round bottom flask equipped with a thermometer, a reflux condenser, a dropping funnel and a steel propeller type agitator, and the temperature was raised to 120°C with agitation to completely dissolve the 2Mz. Subsequently, while agitation was continued and the temperature was kept at 120°C, a solution prepared by dissolving 680 g (3.65 equivalent) of bisphenol A diglycidyl ether epoxy resin having an epoxy equivalent weight of 186 (hereinafter referred to as "BADGE" or "EPIKOTE∗ 828", a product of Yuka Shell Epoxy K.K.) in 300 g of xylene was added dropwise from the dropping funnel over a period of 90 minutes. The adduct which formed was insoluble in xylene and was precipitated as a viscous mass as the reaction progressed. The reaction was further continued for 2 hours to reach a conversion of at least about 98% and then, the temperature of the contents in the flask was lowered to room temperature. Agitation was stopped and the xylene in the upper layer was removed by decantation. Then, the remaining contents of the flask were heated to 140°C to remove the remaining xylene by distillation under a reduced pressure of 10 mm Hg. The molten adduct was poured onto a shallow dish and cooled to room temperature to yield reddish brown adduct mass. This product was crushed and repeatedly pulverized by a jet mill and finally classified to give particles of the adduct in a pulverized shape having a volume average Stokes particle size of 2.9 mm.

The fine powder of the pulverized particles of the 2Mz/BADGE adduct thus obtained is called "Curing Agent C" .

## Curing Agent "S" (for Comparative Examples 3 and 5)

2Mz 28.0 g (0.34 equivalent) and a graft copolymer of poly [(styrene-co-glycidyl methacrylate)-g-methyl methacrylate] (hereinafter referred to as "RESEDA™ GP-300", a product of Toagosei Chemical Ind. Co., Ltd.) 4.54 g as the dispersion stabilizer were charged in a 1,000 mP three-necked round bottom flask equipped with a thermometer, a reflux condensor and a halfmoon-shaped Teflon™ agitator, and methyl iso-butyl ketone (hereinafter referred to as "MIBK" 542.53 g was added thereto. Then, the temperature was raised to 70°C to completely dissolve the mixture. Further, 125.60 g (0.34 equivalent) of a 50% MIBK solution of EPIKOTE™ 828 was added to the resulting solution and the reaction was carried out at 70°C for 9 hours with agitation at a rate of 300 r.p.m. The reaction mixture which was initially clear and colorless gradually changed to milky white opaque liquid as the reaction progressed. In the final stage of the reaction, the reaction mixture became a milky white dispersion tinged with creamy color.

When the reaction was carried out at 70°C for 9 hours to reach a conversion of 100%, the reaction mixture was cooled to room temperature and spray-dried by means of a spray dryer designed for organic solvent system (Model GS-31, manufactured by Yamato Kagaku K.K.) to recover the particles of curing agent. The conditions for spray-drying are as follows.

Temperature at the entrance to the drying chamber : 100°C

Temperature at the exit from the drying chamber : 74°C

Temperature at the exit from the condenser : 16°C

Diameter of spray nozzle: 0.4 mm

Spray pressure : 1.2 kg/cm2

Flow rate of hot $N_2$ gas : 0.5 m3/min.

Liquid feeding rate : 10 g/min.

By spray-drying, a nearly theoretical amount of the particles of curing agent was recovered as dried white powder. Observation by scanning electron microscopy has revealed that the particles of curing agent were recovered almost as primary particles. The volume average particle size of the particles of curing agent was 2.8 mm. The recovery rate of MIBK as the solvent was 99.2%.

The fine powder of spherical particles of the 2Mz/BADGE adduct is called "Curing Agent S".

## Curing Agent "SP" (Powder Type Microencapsulated Latent Curing Agent of Examples 1-3 and 7-10)

The spherical particles of the adduct of Curing Agent S as obtained in the above described reaction were treated with a polyfunctional epoxy compound and a carboxylic acid, and then reacted with a polyfunctional isocyanate compound in an amount of 16% by weight based on the weight of the adduct ($W_s/A = 0.10$ g/m2) to obtain a powder type microencapsulated latent curing agent. The details are as follows.

2Mz 24.0 g and RESEDA™ GP-300 3.90 g were charged in a 1,000 mP four-necked round bottom flask equipped with a thermometer, a reflux condenser, a dropping funnel and a halfmoon-shaped Teflon™ agitator, and MIBK 465.03 g was added thereto. Then, the temperature was raised to 70°C to completely dissolve the 2Mz and RESEDA™ GP-300. Further, 107.66 g of a 50% MIBK solution of EPIKOTE™ 828 was added to the solution, and the reaction was carried out at 70°C for 9 hours with agitation at a rate of 300 r.p.m. Subsequently, 51.01 g of a 50% MIBK solution of EPIKOTE™ 828 and, in addition, 21.43 g of MIBK for washing were added and the reaction was further carried out at 70°C for 4 hours. Then, 71.50 g of a 30% MIBK solution of 2-ethylhexanoic acid was gradually added to the reaction system dropwise from the dropping funnel. After completion of the addition, the reaction was carried out at 70°C for 3 hours. Finally, 128.70 g of a 10% MIBK solution of diphenylmethane-4,4'- diisocyanate (hereinafter referred to as "MDI", "MILLIONATE™ MT", a product of Nippon Polyurethane Industry Co., Ltd.) was added dropwise from the dropping funnel over a period of 120 minutes. After completion of the addition, the reaction was further carried out at 70°C for 10 hours to reach a conversion of nearly 100%. In the final stage of the reaction, the reaction mixture became a milky white uniform and stable dispersion tinged with cream color. The dispersion of the particles of curing agent were subjected to flocculation and sedimentation with n-hexane and the particles were recovered by filtration on a glass filter and further dried in vacuum at 40°C for 3 days to nearly quantitatively yield dried white powder. The volume average particle size of the particles of curing agent was 3.3 mm.

The powdery microencapsulated latent curing agent of the present invention thus obtained is called "Curing Agent SP".

**Curing Aaent "CP" (Powdery Microencapsulated Latent Curing Agent of Example 4)**

The pulverized particles of the adduct of Curing Agent C as obtained in the above described reaction were treated with a polyfunctional epoxy compound and a carboxylic acid, and then reacted with a polyfunctional isocyanate compound in an amount of 20% by weight based on the weight of the adduct ($W_s/A = 0.12$ g/m2) to obtain a powdery type microencapsulated latent curing agent. The details are as follows.

In a 1,000 mP four-necked round bottom flask equipped with a thermometer, a reflux condenser, a dropping funnel and a halfmoon-shaped Teflon™ agitator 80.0 g of the fine powder of Curing Agent C as obtained in Comparative Example, and 530.0 g of cyclohexane and 6.0 g of a 40% toluene solution of a quaternarized amine-modified polyester (hereinafter referred to as "HYPERMER™ LP8", a product of I.C.I. Ltd.) as the dispersion stabilizer were added thereto. Then, while the mixture was agitated at a rate of 400 r.p.m., the temperature was raised to 60°C to form a uniform dispersion. To the dispersion 52.50 g of a 50% MIBK solution of EPIKOTE™ 828 was added dropwise from the dropping funnel over a period of 60 minutes and after completion of the addition, the reaction was further carried out at 60°C for 8 hours. Then, 36.80 g of a 30% cyclohexane solution of 2-ethylhexanoic acid was gradually added dropwise from the dropping funnel and after completion of the addition, the reaction was carried out at 60°C for 4 hours. Finally, 160.0 g of a 10% cyclohexane solution of MDI was added dropwise from the dropping funnel over a period of 180 minutes. After completion of the addition, the reaction was further carried out at 60°C for 20 hours to reach a conversion of about 100%. In the final stage of the reaction, the reaction mixture became a uniform dispersion with cream color. The dispersion of the particles of curing agent was transferred into a 2,000 ml beaker and left to stand overnight to allow the particles to settle. The particles were recovered by filtration on a glass filter and further dried in vacuum at 45°C for 2 days to yield yellowish particles. The volume average Stokes particle size of the particles of curing agent was 3.4 mm.

This powdery microencapsulated latent curing agent of the present invention is called "Curing Agent CP".

**Curing Agent "SM" (Masterbatch Type Microencapsulated Latent Curing Agent of Example 5)**

The spherical particles of the 2Mz/bisphenol A diglycidyl ether adduct having an average particle size of 0.2 mm were dispersed in a liquid epoxy resin having few hydroxyl groups to give a uniform dispersion, and a polyfunctional isocyanate compound in an amount of 40% by weight based on the adduct ($W_s/A = 0.02$ g/m2) was added to the dispersion to obtain a masterbatch micro-encapsulated latent curing agent. The details are as follows.

MIBK 3,400 g was charged in a 5,000 mP three-necked round bottom flask equipped with a thermometer, a reflux condenser and a halfmoon-shaped glass agitator, and then 2Mz 115 g (1.39 equivalent) was added to the flask and the temperature was raised to 50°C to completely dissolve the 2Mz. Subsequently, a 25% methyl ethyl ketone/butyl acetate solution of a graft copolymer of poly [(methyl methacrylate-co- methacrylic acid)-g-methyl methacrylate] (hereinafter referred to as "GC-10", a product of Toagosei Chemical Ind. Co., Ltd.) 146 g as the dispersion stabilizer was added thereto, and then a 50% MIBK solution of EPIKOTE™ 828 500 g (1.34 equivalent weight) was added. While the contents were agitated at a rate of 400 r.p.m., the reaction was carried out at 50°C for 24 hours. The reaction mixture, which was initially transparent, gradually turned to bluish translucent complexion, and then changed into a milky opaqueness in the final stage of the reaction. After completion of the reaction, the reaction mixture was cooled down to room temperature, and left to stand overnight to sediment the particles. After removing the supernatant by decantation, the particles were separated by filtration, and then thoroughly washed with MIBK and dried in vacuum at 40°C for 24 hours to obtain 81 g white particles of the adduct. The particle size in the MIBK dispersion immediately after completion of the reaction was measured by a Laser particle analyzer ("LPA 3000/3100", manufactured by Ohtsuka Denshi K.K.). The average particle size was 0.21 mm. According to the observation by electron microscopy, the shape of particles of the 2Mz/BADGE adduct prepared by the precipitation reaction was spherical. Also, it was found from the analysis by an infrared spectrophotometer that part of the dispersion stabilizer used for the formation of particles was immobilized on the particles of the adduct. In an atmosphere of saturated humidity 150 g of the particles of the adduct were left to stand for 48 hours to absorb 5.2% by weight of moisture. Then, the moisture-regulated particles of the adduct were added to 300 g of bisphenol A diglycidyl ether epoxy resin having an epoxy equivalent weight of 173 and containing hardly any hydroxyl groups (hereinafter referred to as "DER™ 332", a product of Dow Chemical Co., Ltd.), and the mixture was roughly kneaded in a mortar and twice passed through a three-roll mill to completely disperse the particles of the adduct in the epoxy resin to obtain a dispersion of 50 phr of the particles of the adduct. Then, 300 g of the dispersion was transferred to a heatable reactor equipped with an agitator and heated at 60°C with agitation. While maintaining this temperature, 40 g of polymethylene polyphenylisocyanate (hereinafter referred to as "MILLIONATE™ MR-300", a product of Nippon Polyurethane Industry Co., Ltd.) was added over a period of about one hour. Then, while maintaining the same temperature, the mixture was agitated under heating for 3 hours, and cooled down to room temperature to obtain a curing agent masterbatch.

This masterbatch type microencapsulated latent curing agent of the present invention is called "Curing Agent SM".

### Curing Agent "CM" (Masterbatch Type Microencapsulated Latent Curing Agent of Example 6)

The pulverized particles of the 2Mz/bisphenol A diglycidyl ether adduct having a volume average Stokes particle size of 2.9 mm (Curing Agent C) were dispersed in a liquid epoxy resin having hardly anhydroxyl groups to give a uniform dispersion, and a polyfunctional isocyanate compound in an amount of 15% by weight based on the weight of the adduct ($W_s/A = 0.09$ g/m2) was added to the dispersion to obtain a masterbatch type microencapsulated latent curing agent. The details are as follows.

To 300 g of DER™ 332 was added 150 g of the pulverized particles of the 2Mz/bisphenol A diglycidyl ether adduct having an average particle size of 2.9 mm as obtained in the above described reaction (Curing Agent C), and the mixture was roughly kneaded in a mortar for about 30 minutes, and three times passed through a three-roll mill to completely disperse the particles of the adduct in the epoxy resin to obtain a dispersion of 50 phr of the particles of the adduct. Then, 300 g of the dispersion was transferred to a reactor equipped with a heatable agitator and heated at 50°C with agitation. While maintaining this temperature, 15 g of MILLIONATE™ MR-300 was added over a period of about one hour. Then, while maintaining the same temperature, the mixture was agitated under heating for 4 hours, and cooled down to room temperature to obtain a curing agent masterbatch.

The masterbatch type microencapsulated latent curing agent of the present invention thus obtained is called "Curing Agent CM".

### Modifying Component (D): Additives

(a) Dicy :     Dicyandiamide ("AMICURE™ AH-150" a product of Ajinomoto Co., Inc.)
(b) Silica:    Crystalline silica powder ("Williams Super-white Silica", a product of Pfizer Co., U.S.A.)

### Preparation of Epoxy Resin Adhesive Compositions of the Present Invention

The addition amount of each component in the epoxy resin adhesive compositions is shown by parts by weight in Table 1. First, the curing agent of component (C) was added to the epoxy resin of component (A) and the mixture was roughly kneaded and then passed through a three-roll mill to completely disperse component (C) in component (A). The dispersion of component (A) and component (C) thus obtained was transferred to an appropriate vessel, and then the modifying agent of component (D) was added thereto and uniformly dispersed therein under agitation with a high-speed mixer ("HOMO DISPER", manufactured by Tokushu Kika K.K.). Finally, the reactive diluent of component (B) was added to the dispersion and completely mixed therewith to prepare epoxy resin adhesive compositions of the present invention and those of Comparative Examples.

With respect to the epoxy resin adhesive compositions, the initial viscosities at 25°C and 40°C, the curing time at 160°C and the increases in viscosity after stored at 40°C for 8 hours and for one week are measured. Furthermore, part of each of the epoxy resin adhesive compositions was heat-cured at 160°C for 30 minutes to form a cured product and the glass transition temperature (Tg) and the water absorption in boiling water were measured. In addition, part of each of the epoxy resin adhesive compositions were applied between two iron plates and cured at 160°C for 10 minutes and the tensile shear bonding strength was measured.

The measuring methods and the apparatus employed are as follows;
Viscosity: Measured by a B type viscometer. (manufactured by Tokyo Keiki Co., Ltd.)
Curing Time (minute): About 5 g of a sample was dropped on a plate previously heated at a predetermined temperature. Then, the period of time necessary for the load on a probe to reach one gram was measured.
Glass Transition Temperature (Tg): Measured by the penetration method with a thermal mechanical analyzer ("TMA", manufactured by Seiko Industries Inc.)
Water Absorption (%): A sample of about 40 mm in diameter and about 4mm in thickness was soaked in boiling water of 100°C for 24 hours, and the increase in weight was measured and the water absorption was calculated from the following equation;

$$\text{water absorption}(\%) = \frac{\text{increase in weight after soaking in boiling water}}{\text{weight before soaking in boiling water}} \times 100$$

15

## Table 1

### Epoxy Resin Adhesive Compositions

| Composition | Comparative Example No. | | | | | Example No. | | | | | | | | | |
|---|---|---|---|---|---|---|---|---|---|---|---|---|---|---|---|
| | 1 | 2 | 3 | 4 | 5 | 1 | 2 | 3 | 4 | 5 | 6 | 7 | 8 | 9 | 10 |
| Component (A) | | | | | | | | | | | | | | | |
| EP 825[1] | 85 | – | 65 | 85 | 85 | 85 | 85 | 85 | 85 | 61 | 63 | 65 | 65 | – | – |
| EP 807[2] | – | 85 | – | – | – | – | – | – | – | – | – | – | – | 93 | 85 |
| Component (B) | | | | | | | | | | | | | | | |
| CGE[3] | 15 | – | – | 15 | 15 | 15 | 15 | 15 | 15 | 15 | 15 | – | – | 7 | – |
| CYH[4] | – | 15 | – | – | – | – | – | – | – | – | – | – | – | – | 15 |
| MHHPA[5] | – | – | 35 | – | – | – | – | – | – | – | – | 35 | 35 | – | – |
| Component (C) | | | | | | | | | | | | | | | |
| Curing Agent S* | 10 | 10 | – | – | – | – | – | – | – | – | – | – | – | – | – |
| Curing Agent C* | – | – | 10 | 10 | 10 | – | – | – | – | – | – | – | – | – | – |
| Curing Agent SP | – | – | – | – | – | 15 | 15 | 15 | – | – | – | 15 | 15 | 15 | 15 |
| Curing Agent CP | – | – | – | – | – | – | – | – | 15 | – | – | – | – | – | – |
| Curing Agent SM | – | – | – | – | – | – | – | – | – | 34 | – | – | – | – | – |
| Curing Agent CM | – | – | – | – | – | – | – | – | – | – | 32 | – | – | – | – |
| Modifying Component (D) | | | | | | | | | | | | | | | |
| (a) Dicy[6] | – | – | – | – | 3 | – | 3 | 3 | 3 | 3 | 3 | – | – | 3 | 3 |
| (b) Silica[7] | – | – | – | – | 20 | – | – | 20 | 20 | 20 | 20 | – | 20 | 20 | 20 |
| Initial viscosity (cP) | | | | | | | | | | | | | | | |
| 25°C | 1,530 | 1,330 | 1,140 | 2,100 | 3,600 | 1,830 | 1,850 | 2,800 | 3,380 | 3,200 | 3,520 | 1,950 | 3,500 | 3,350 | 3,100 |
| 40°C | 440 | 415 | 330 | 580 | 900 | 530 | 550 | 720 | 850 | 830 | 890 | 450 | 890 | 850 | 820 |

1) EP 825: Bisphenol A diglycidyl ether epoxy resin having an epoxy equivalent weight of 175 (EPIKOTE® 825, a product of Yuka Shell Epoxy K.K.)

EP 0 590 975 A1

## Table 1 (- continued)

2) EP 807: Bisphenol F diglycidyl ether epoxy resin having an epoxy equivalent weight of 170 (EPIKOTE® 807, a product of Yuka Shell Epoxy K.K.)

3) CGE : A mixture of m- and p-cresylglycidyle ether (a product of Sakamoto Yakuhin Kogyo K.K.)

4) CYH : Cyclohexane dimethanol diglycidyl ether ("HEROXY MK-107", a product of ACI Japan Ltd.)

5) MHHPA : Methylhexahydrophthalic anhydride ("HN-5500E", a product of Hitachi Kasei Kogyo K.K.)

6) Dicy : Dicyandiamide ("AMICURE AH-150", a product of Ajinomoto K.K.)

7) Silica: Crystalline silica powder ("Williams Super-White Silica" a product of Pfizer Co., U.S.A.)

*: Comparative curing agent

## Table 2

### Properties of Epoxy Resin Adhesive Compositions

| Composition | Comparative Example No. | | | | | Example No. | | | | | | | | | |
|---|---|---|---|---|---|---|---|---|---|---|---|---|---|---|---|
| | 1 | 2 | 3 | 4 | 5 | 1 | 2 | 3 | 4 | 5 | 6 | 7 | 8 | 9 | 10 |
| Increase in viscosity after | | | | | | | | | | | | | | | |
| 40°C x 8 hours | Gelled | Gelled | Gelled | Gelled | Gelled | 1.1 | 1.1 | 1.1 | 1.1 | 1.1 | 1.1 | 1.1 | 1.1 | 1.1 | 1.1 |
| 40°C x 1 week | Gelled | Gelled | Gelled | Gelled | Gelled | 1.3 | 1.3 | 1.4 | 1.6 | 1.5 | 1.6 | 1.8 | 4.2 | 1.4 | 1.5 |
| Curing Time (sec/160°C) | 26 | 25 | 18 | 26 | 26 | 26 | 25 | 25 | 25 | 24 | 26 | 20 | 19 | 27 | 27 |
| Bonding Strength (kgf/cm²) | 100 | 105 | 115 | 106 | 135 | 101 | 130 | 136 | 134 | 135 | 136 | 116 | 120 | 130 | 134 |
| Tg (°C) | 105 | 112 | 123 | 105 | 106 | 104 | 105 | 108 | 109 | 106 | 108 | 127 | 125 | 106 | 122 |
| Water Absorption (%) | 3.5 | 3.2 | 2.9 | 3.6 | 2.8 | 3.5 | 3.7 | 2.7 | 2.8 | 2.6 | 2.8 | 3.2 | 2.8 | 2.9 | 3.2 |

The compositions as in Table 1 were prepared in such a manner that, even with the addition of a required amount of a filler such as silica, they can still be sprayed at 40°C, i.e., the upper limit of the viscosity is about 1,000 cP. Without addition of any filler as in Examples 1, 2 and 7, the viscosities of the compositions would be as low as about 500 cP and thus the compositions can be used for impregnation of prepreg for the fabrication of laminated products.

In order to prepare an adhesive composition which can be spray-coated at 40°C, if general-purpose liquid bisphenol A diglycidyl ether type epoxy resin such as EPIKOTE™ 828 having an epoxy equivalent weight of about 190 and a viscosity at 25°C of about 12,000 cP (a product of Yuka Shell Epoxy K.K.) is used, a larger amount of the reactive diluent as component (B) must be added since the viscosity of the epoxy resin itself is high. This is disadvantageous because it often causes a drastic decrease in the cured physical properties. Thus, it is preferred to use an epoxy resin with a lower epoxy equivalent weight or a lower degree of polymerization, such as EPIKOTE™ 825. Furthermore, since bisphenol F diglycidyl ether type epoxy resin such as EPIKOTE™ 807 has a relatively lower viscosity than the bisphenol A diglycidyl ether type epoxy resin, the degree of freedom of formulation will be higher. Thus, as the examples of component (A), EPIKOTE™ 825 and EPIKOTE™ 807 were used as shown in Table 1.

The viscosity of the composition will increase if component (C) which is a curing agent for the epoxy resin as component (A) and a filler are added. As the general estimate, if the viscosity at 25°C exceeds 4,000 cP, the viscosity at 40°C will exceed 1,000 cP and thus, it will be difficult to conduct spray-coating. Therefore, the reactive diluent as component (B) is an essential component in the composition of the present invention. In the Examples and Comparative Examples, the monofunctional epoxy compound of CGE, the bifunctional epoxy compound of CYH, and the liquid acid anhydride of MHHPA were used as component (B). Since their viscosities at 25°C were 5 to 10 cP, 55 to 75 cP, and 70 cP, respectively, the monofunctional epoxy compound is the most effective reactive diluent because its viscosity is substantially lower. On the other hand, from the viewpoint of the heat resistance of the cured product, the polyfunctional epoxy compound and the liquid acid anhydride are better. Accordingly, a proper selection of the reactive diluent is required depending on the desired viscosity of the composition, the curing property, the storage stability and the cured physical properties.

The microencapsulated latent curing agent as component (C) of the present invention plays a very important role in the preparation of a low viscosity one-component epoxy resin adhesive composition having excellent bondability, heat resistance and storage stability, as shown in the evaluation results of the properties of Examples 1 to 10 in Table 2. The one-component adhesive composition can be made only by using the microencapsulated latent curing agent as component (C). As shown in the Comparative Examples 1 to 5 in Table 2, when non-encapsulated Curing Agent S and Curing Agent C were used, irrespective of the preparation method of the amine type curing agent or the particles of either a spherical shape or a pulverized shape, the particles of the curing agent were easily dissolved in the reactive diluent and did not show any latency. As a result, all the diluting systems gelled at 40°C within 8 hours which corresponded to the one day's operation time. In contrast, when the microencapsulated latent curing agents which are components (C) of the present invention, i.e., Curing Agents SP, CP, SM and CM which were encapsulated with a polyfunctional isocyanate compound, were used, the solvent resistance of the particles of the curing agent became stronger, and thus all the diluting systems showed substantially better storage stability regardless of the shape of particles of the curing agent, i.e., of either a spherical shape or a pulverized shape, and the supplying style of the particles of the curing agent, i.e., of either a powder type or of a masterbatch type. All the diluting systems in Examples 1 to 10 hardly increased in viscosity at 40°C for 8 hours which was the one day's operation time, and the ratio of increase in viscosity after storing for one week was substantially lower. This promises automation of the spray coating adhesion and stabilization of the product quality. In comparing Example 1 with Comparative Example 1 and also in comparing Example 4 with Comparative Example 5, the effect of the encapsulation is more clear. The addition amounts of the curing agents in Examples 1 to 10 were determined for providing nearly the same amine concentration as in Comparative Examples 1 to 5, in other words, 10 parts by weight of the imidazole adducts per 100 parts by weight of the combined amount of component (A) and component (B) were used. If the amine concentration is the same, obviously the curing rate will remain nearly the same, and thus there will be no effect of the encapsulation on the curing reaction. All these systems showed that they could be cured in about 25 seconds at 160°C, thus showing a quick curability. Investigation was carried out with Examples 3, 4, 5, and 6 in order to clarify the effects of the particle shape of the microencapsulated latent curing agent and the style of its supply on the properties of the composition. In this case, they were added at the same amine concentration. As clearly seen from the results shown in Table 1, the viscosity of the composition was lower with spherical particles than with the pulverized particles, and with the powder type than with the masterbatch type and as a result, the former were more advantageous. It is also obvious from Table 2 that the storage stability, curing rate, bonding strength, heat resistance and water resistance remain nearly unchanged.

Although the composition made of the three essential components (A), (B) and (C) of the present invention as in Example 1 showed an acceptable bonding strength and heat resistance (Tg), but an even higher bonding strength could be obtained by adding an appropriate amount of Dicy which is modifying component (D) as in Example 2.

Further, the system with silica filler added as in Example 3 can, both reduce the shrinkage caused by curing process and the cost of product, and also improve the bonding strength and the water resistance. Although the general tendency of the system with silica added shows poor storage stability, such an effect was not significant in the present invention.

When a liquid acid anhydride was used as the reactive diluent of component (B) as in Examples 7 and 8, the long-term storage stability was relatively inferior to the case where a monofunctional or bifunctional epoxy compound was used, but it showed, as the characteristic feature, a faster curing rate and a higher heat resistance (Tg). Furthermore, when a monofunctional epoxy compound was compared to a bifunctional epoxy compound as in Example 9 vs Example 10, the curing rate and the water absorption did not change so much, but the system using the bifunctional epoxy compound (CYH) showed improvement on both the bonding strength and the heat resistance.

As described above, when the three components, i.e., (A) a liquid epoxy resin at room temperature, (B) a reactive diluent and (C) a microencapsulated amine type latent curing agent of the present invention are used as the essential components, it is possible to prepare a low viscosity, quickly curable, solvent-free, non-polluting one-component epoxy resin adhesive composition having excellent bondability, cured physical properties and storage stability. By taking advantage of these characteristic features, it is possible to automate the spray-coating or painting process, to improve productivity of the line, to stabilize the quality of products and to maintain a good working environment.

With these characteristic features, the composition of the present invention can provide a one-component epoxy resin adhesive composition for various applications. Examples of the fields where the composition of the present invention can be applied are a field of structural adhesives such as adhesives for assembly of vehicles, adhesives for assembly of optical equipment and adhesives for assembly of electronic and electrical equipment; a field of paints such as primer for metallic anti-corrosion and paint for printing; a field of electronics such as glass impregnating materials for printed circuit substrates, encapsulating materials for IC chips, electrically conductive paints, solder resist ink, adhesives for die bonding, adhesives for printed substrates and electrically conductive adhesives; and a field of electrical applications such as electrical insulating materials, coil impregnating materials, battery casing adhesives and tape head adhesives.

## Claims

1. A substantially solvent-free one-component type epoxy resin adhesive composition which comprises:
   (A) 100 parts by weight of an epoxy resin which is a liquid polyfunctional epoxy compound at room temperature,
   (B) 5 to 100 parts by weight of a reactive diluent and
   (C) 1 to 100 parts by weight of a microencapsulated amine type latent curing agent.

2. The composition of Claim 1, wherein said epoxy resin (A) is bisphenol A diglycidyl ether or bisphenol F diglycidyl ether.

3. The composition of Claim 1 or 2, wherein said reactive diluent (B) is a monofunctional or polyfunctional epoxy compound having a viscosity of not greater than 1000 cP at room temperature, preferably
   a) cresyl glycidyl ether, or
   b) cyclohexane dimethanol diglycidyl ether.

4. The composition of Claim 1 or 2, wherein said reactive diluent (B) is a liquid acid anhydride having a viscosity of not greater than 1000 cP at room temperature, preferably methylhexahydrophthalic anhydride.

5. The composition of any preceding claim, wherein said microencapsulated amine type latent curing agent is a powder type or masterbatch type curing agent comprising particles of a curing agent having latency by the microencapsulation of pulverized or spherical particles of an amine compound/epoxy compound adduct with 0.01 g to 0.5 g of a polyfunctional isocyanate compound per square meter of the surface area of said particles of the amine compound/epoxy adduct.

6. The composition of Claim 5, wherein said pulverized or spherical particles of the amine compound/epoxy compound adduct has a microencapsulating layer formed from a polyfunctional epoxy compound on their surface, which is preferably bisphenol A diglycidyl ether or bisphenol F diglycidyl ether.

7. The composition of Claim 5, wherein said pulverized or spherical particles of the amine compound/epoxy compound adduct is modified with a carboxylic acid.

8. The composition of Claim 6, wherein the pulverized or spherical particles of the amine compound/epoxy compound adduct having an microencapsulating layer formed from the polyfunctional epoxy compound on their surfaces is modified with a carboxylic acid.

9. The composition of Claim 7 or Claim 8, wherein said carboxylic 2-ethylhexanoic acid.

10. The composition of any of claims 5 to 9, wherein the epoxy compound of said amine compound/epoxy adduct is a bisphenol A diglycidyl ether or bisphenol F diglycidyl ether.

11. The composition of any of claims 5 to 10, wherein the amine compound of said amine compound/epoxy compound adduct is 2-methylimidazole.

12. The composition of any of claims 5 to 11, wherein said polyfunctional isocyanate compound in said microencapsulated amine type latent curing agent is selected from
    a) diphenyl-methane-4,4'-diisocyanate, and
    b) polymethylene polyphenylisocyanate.

13. The composition of any preceding claim further comprising 0.1 to 100 parts by weight, based on 100 parts by weight of the combined amount of said liquid polyfunctional epoxy compound at room temperature (A) and said reactive diluent (B), of a modifying agent selected from the group consisting of a sedimentation inhibitor, a plasticizer, a filler and a pigment.

14. The composition of Claim 13, wherein said filler is silica.

15. The composition of any preceding claim additionally comprising 0.1 to 50 parts by weight, based on 100 parts by weight of said liquid polyfunctional epoxy compound at room temperature (A), of a curing agent, preferably dicyandiamide.

16. A composition according to any preceding claim which has a viscosity of less than 1000 cP at 40°C.

17. Method of preparing a substantially solvent-free one-component type epoxy resin adhesive composition by mixing and homogeneously blending
    (A) 100 parts by weight of an epoxy resin which is a liquid polyfunctional epoxy compound at room temperature,
    (B) 5 to 100 parts by weight of a reactive diluent and
    (C) 1 to 100 parts by weight of a microencapsulated amine type latent curing agent.

18. Use of a microencapsulated amine type curing agent as a latent curing agent in a substantially solvent-free one-component type epoxy resin adhesive composition which comprises:
    (A) 100 parts by weight of an epoxy resin which is a liquid polyfunctional epoxy compound at room temperature,
    (B) 5 to 100 parts by weight of a reactive diluent and
    (C) 1 to 100 parts by weight of the said microencapsulated agent.

19. Use of a composition according to any of claims 1 to 16 as an adhesive.

20. Use according to claim 19 in which the composition is used in a method in which the composition is cured by subjecting it to a curing temperature of at least about 150°C.

21. Use according to claim 19 or 20 in which the composition is applied to a substrate by spraying.

**European Patent Office**

## EUROPEAN SEARCH REPORT

Application Number

EP 93 30 7751

### DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| X | DATABASE WPI Week 9115, Derwent Publications Ltd., London, GB; AN 91-106095 & JP-A-3 048 416 (NITSUKO,) 1 March 1991 * abstract * --- | 1-21 | C08G59/18 C08J3/24 C09J163/00 |
| P,X | EP-A-0 552 976 (W.R. GRACE) * page 12, line 40 - line 48; claims * --- | 1-21 | |
| X | DATABASE WPI Week 9205, Derwent Publications Ltd., London, GB; AN 92-036248 & JP-A-3 281 625 (SOMAR CORP) 12 December 1991 * abstract * --- | 1-21 | |
| X | DATABASE WPI Week 9105, Derwent Publications Ltd., London, GB; AN 91-032024 & JP-A-2 300 229 (SUMITOMO BAKELITE) 12 December 1990 * abstract * --- | 1-4 | TECHNICAL FIELDS SEARCHED (Int.Cl.5) C08G C08J C09J |
| A | DATABASE WPI Week 9103, Derwent Publications Ltd., London, GB; AN 91-019207 & JP-A-2 292 325 (NITTO DENKO CORP) 3 December 1990 * abstract * --- -/-- | 1 | |

The present search report has been drawn up for all claims

| Place of search | Date of completion of the search | Examiner |
|---|---|---|
| THE HAGUE | 26 January 1994 | Deraedt, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int.Cl.5) |
|---|---|---|---|
| A | DATABASE WPI<br>Week 9021,<br>Derwent Publications Ltd., London, GB;<br>AN 90-160448<br>& JP-A-2 102 281 (HITACHI CHEMICAL KK) 13 April 1990<br>* abstract *<br>----- | 1 | |

TECHNICAL FIELDS
SEARCHED     (Int.Cl.5)

The present search report has been drawn up for all claims

| Place of search | Date of completion of the search | Examiner |
|---|---|---|
| THE HAGUE | 26 January 1994 | Deraedt, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document